# EUROPÄISCHE PATENTANMELDUNG

(11) **EP 0 637 561 A1**
(43) Veröffentlichungstag der Anmeldung: **08.02.1995**
(21) Anmeldenummer: 94111985.1
(22) Anmeldetag: 01.08.1994
(51) Int. Cl.: B65G 49/07, B65G 47/252

(54) **Verfahren und Anordnung zum Umsetzen von Leiterplatten von einer ersten Transportebene auf eine zweite mit etwa gleichem Niveau**

(30) Priorität: 04.08.1993 DE 4326225
(71) Anmelder: Siemens Nixdorf Informationssysteme AG, D-33106 Paderborn (DE)
(72) Erfinder: Merkenschlager, Hans-Hermann, Dipl. Ing., D-86179 Augsburg (DE)
(74) Vertreter: Fuchs, Franz-Josef, Dr.-Ing.

(57) **Zusammenfassung**

Die Erfindung bezieht sich auf ein Verfahren und eine Anordnung zum Umsetzen von Leiterplatten von einer ersten Transportebene auf eine zweite Transportebene mit etwa gleichem Niveau mittels eines drehbaren Fächerspeichers mit radial zur Drehachse aufgesetzten Fächern. Die bekannten Fächerstapler dieser Art können nur starre Leiterplatten umsetzen und sind zudem nicht stauüberbrückend ausgebildet. Diese Nachteile werden durch das erfindungsgemäße Verfahren dadurch beseitigt, daß auf der ersten Transportebene (1) ankommende Leiterplatten (6) in die nach jeder Beschickung einen Schritt weiter drehenden Fächer (4, 5) des Fächerspeichers (3) eingeschoben werden. Ein von der Entladestation (7) der zweiten Transportebene (2) gesteuerter Greifer (8) entnimmt den jeweils vordersten, mit einer Leiterplatte (6) bestückten Fächer (4) in der Ein-Auslaufzone und führt ihn zur Entladestation (7). Den leeren Fächer (5) bringt er zum letzten freien Platz am Fächerspeicher (3) unterhalb der Transportebenen (1, 2). Anschließend holt er den nächsten beschickten Fächer (4) zur Entladestation (7). Durch dieses Verfahren wird eine Staubewältigung bei der Umsetzung von Leiterplatten erzielt. Zudem ist dieses Verfahren und die Anordnung dazu auch für Leiterplatten mit dünnen Kernen geeignet.

## Beschreibung

Die Erfindung betrifft ein Verfahren zum Umsetzen von Leiterplatten von einer ersten Transportebene auf eine zweite Transportebene mit etwa gleichem Niveau mittels eines drehbaren Fächerspeichers mit radial zur Drehachse aufgesetzten Fächern.

Bei der Verarbeitung von Leiterplatten ist es häufig erforderlich, auf einer ersten Transportebene ankommende Leiterplatten auf eine zweite Transportebene umzuschichten. Dabei sind bisher nur starre Fächerspeicher verwendet worden, die auf einen eventuell auftretenden Leiterplattenstau nicht flexibel reagieren.

Aufgabe der vorliegenden Erfindung ist es, ein Verfahren und eine Anordnung zum Umsetzen von Leiterplatten von einer ersten Transportebene auf eine zweite Transportebene anzugeben, die eine stauauffangende Arbeitsweise ermöglichen.

Zur Lösung dieser Aufgabe wird dabei so verfahren, daß auf der ersten Transportebene ankommende Leiterplatten in die nach jeder Beschickung einen Schritt weiter drehenden Fächer des Fächerspeichers eingeschoben werden, daß ein von der Entladestation der zweiten Transportebene gesteuerter Greifer den jeweils vordersten, mit einer Leiterplane bestückten Fächer in der Ein-Auslaufzone oberhalb der Transportebenen entnimmt ihn bis zur Entladestation auf der zweiten Transportebene dreht und den leeren Fächer dem letzten freien Platz am Fächerspeicher unterhalb der Transportebenen zuführt und anschließend den nächsten beschickten Fächer zur Entladestation holt. Bei Erreichen einer Staubewältigungsgrenze wird der Leiterplattennachschub auf der ersten Transportebene unterbrochen.

Die Anordnung zur Durchführung des Verfahrens ist dabei so ausgebildet, daß der Fächerspeicher eine auf einer Achse befestigte Drehscheibe enthält, auf derem Umfang radial nach außen stehende Fächer aufklinkbar angeordnet sind, daß oberhalb der Transportebenen nur beschickte Fächer und unterhalb der Transportebenen nur leere Fächer vorgesehen sind, daß sich die Drehscheibe nach jeder Beschickung um einen Schritt weiterdreht, und daß auf der Drehachse der von der Entladestation steuerbare Greifer in beiden Drehrichtungen frei beweglich befestigt ist.

Durch diese Maßnahmen wird eine atmende Arbeitsweise des Fächerspeichers erreicht. Außerdem ist dadurch, daß jedem Fach nur eine Leiterplatte zugeordnet ist, die in ihrer vollen Größe im Fächer aufliegt und der Greifer den gefüllten Fächer, aber nicht die Leiterplatte erfaßt, das Verfahren nicht nur für starre Leiterplattenmaterialien, sondern auch für dünne Kerne, z.B. von einer Dicke von ca. 0,1 mm geeignet.

Anhand des Ausführungsbeispiels wird die Erfindung näher erläutert. Der Fächerspeicher 3 besteht aus der Drehscheibe 10, an deren Umfang radial nach außen abstehende Fächer 4, 5 angeordnet sind, wobei sich die beschickten Fächer 4 oberhalb der Transportebenen 1, 2 befinden, während die leeren Fächer 5 in der Vorratsebene unterhalb der Transportebenen 1, 2 angeordnet sind. Auf der Achse 9 ist neben der Drehscheibe 10 der in beiden Richtungen frei bewegliche Greifer 8 befestigt. Je nach Stau zwischen den zu verbindenden Transportebenen 1, 2, die Laufbänder von Prozeßlinien sein können, verändert sich die Anzahl der mit Leiterplatten 6 gefüllte Fächer 4 in der aktiven Speicherzone oberhalb der Transportebenen 1, 2. Beim Durchlauf wird das Prinzip "first in-first out" beibehalten. Sowohl die leeren als auch die gefüllten Fächer 4, 5, sind an der Drehscheibe 10, die nach jedem Beschickvorgang um einen Schritt weiterdreht, einklinkbar. Der Greifer 8 ist in der Drehachse 9 frei beweglich und entnimmt der Drehscheibe 10 den jeweils vordersten beschickten Fächer 4, dreht ihn bis zur Entladestation 7 und führt ihn nach der Entleerung in der Entladestation 7 dem letzten freien Platz 11 auf der Drehscheibe 9 unterhalb der Transportebenen 1, 2 zu. Anschließend holt er dann den nächsten beschickten Fächer 4 zur Entladestation 7. Durch die strahlenförmige Anordnung der Fächer 4, 5 um die horizontale Drehachse 9 senkrecht zur Transportrichtung, wird eine vorteilhafte und kostengünstige Ausführung des Fächerspeichers 3 erreicht.

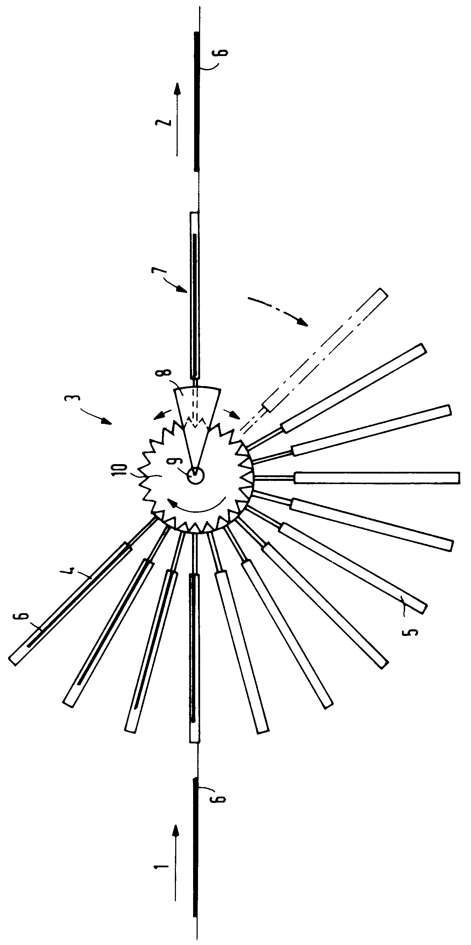

## Patentansprüche

1. Verfahren zum Umsetzen von Leiterplatten von einer ersten Transportebene auf eine zweite Transportebene mit etwa gleichem Niveau mittels eines drehbaren Fächerspeichers mit radial zur Drehachse aufgesetzten Fächern,
**dadurch gekennzeichnet,**
daß auf der ersten Transportebene (1) ankommende Leiterplatten (6) in die nach jeder Beschickung einen Schritt weiter drehenden Fächer (4, 5) des Fächerspeichers (3) eingeschoben werden, daß ein von der Entladestation (7) der zweiten Transportebene (2) gesteuerter Greifer (8) den jeweils vordersten, mit einer Leiterplatte (6) bestückten Fächer (4) in der Ein-Auslaufzone oberhalb der Transportebenen (1, 2) entnimmt, ihn bis zur Entladestation (7) auf der zweiten Transportebene (2) dreht und den leeren Fächer (5) dem letzten freien Platz (9) am Fächerspeicher (3) unterhalb der Transportebenen (1, 2) zuführt und anschließend den nächsten beschickten Fächer (4) zur Entladestation (7) holt.

2. Verfahren zum Umsetzen von Leiterplatten nach Anspruch 1,
**dadurch gekennzeichnet,**
daß bei Erreichen der Staubewältigungsgrenze der Leiterplattennachschub auf der ersten Transportebene (1) unterbrochen wird.

3. Anordnung zur Durchführung des Verfahrens nach Anspruch 1,
**dadurch gekennzeichnet,**
daß der Fächerspeicher (3) eine auf einer Achse (9) befestigte Drehscheibe (10) enthält, auf deren Umfang radial nach außen stehende Fächer (4, 5) aufklinkbar angeordnet sind, daß oberhalb der Transportebenen (1, 2) nur beschickte Fächer (4) und unterhalb der Transportebenen (1, 2) nur leere Fächer (5) vorgesehen sind, daß sich die Drehscheibe (10) nach jeder Beschickung um einen Schritt weiterdreht, und daß auf der Drehachse (9) der von der Entladestation (7) steuerbare Greifer (8) in beiden Drehrichtungen frei beweglich befestigt ist.
